# FASCICULE DE BREVET EUROPEEN

(11) **EP 1 454 516 B1**
(45) Date de publication et mention de la délivrance du brevet: **13.08.2008**
(21) Numéro de dépôt: 02804613.4
(22) Date de dépôt: 12.12.2002
(51) Int. Cl.: H05K 7/20, H05K 1/02

(54) **MODULE DE PUISSANCE ET ENSEMBLE DE MODULES DE PUISSANCE**
ENERGIEMODUL UND ENERGIEMODULBAUGRUPPE
POWER MODULE AND POWER MODULE ASSEMBLY

(30) Priorité: 13.12.2001 FR 0116153
(43) Date de publication de la demande: 08.09.2004
(73) Titulaire: Valeo Electronique et Systèmes de Liaison, 78180 Montigny le Bretonneux (FR)
(72) Inventeur: MORELLE, Jean-Michel, F-45190 Beaugency (FR)
(74) Mandataire: de la Bigne, Guillaume Michel Marie
(86) Numéro de dépôt international: PCT/FR2002/004323
(87) Numéro de publication internationale: WO 2003/051095

(56) Documents cités:
- EP-A- 1 009 195
- US-A- 5 285 352
- US-A- 5 812 375
- US-A- 2001 030 362
- US-A1- 2001 026 438

## Description

La présente invention concerne un ensemble comprenant au moins un module de puissance d'un seul tenant comprenant au moins une trace métallique découpée, au moins un composant électronique de puissance relié électriquement à la trace métallique découpée et un matériau isolant électriquement assurant la cohésion du module de puissance. Ce dernier présente en outre une face de refroidissement destinée à être mise en contact direct avec des moyens de refroidissement extérieurs au module.

L'invention concerne également un ensemble de tels modules de puissance.

En général, un module de puissance du type précité comporte au moins un composant électronique de puissance brasé ou collé sur un substrat.

Ce substrat est, par exemple un substrat de type DBC (pour « Direct Bounded Copper »), qui comporte trois couches. Une première couche est constituée d'une trace métallique gravée formant les liaisons d'un circuit électrique, une deuxième couche intermédiaire est une plaque de matériau isolant électriquement tel qu'une céramique, par exemple de l'oxyde d'alumine, et une troisième couche est une plaque métallique constituée de cuivre ou de cuivre nickelé. L'ensemble constitué du substrat de type DBC et des composants électroniques de puissance brasés ou collés est à son tour brasé sur une plaque de cuivre, formant support mécanique et dissipateur thermique.

Le substrat peut également être de type SMI (Substrat Métallique Isolé). Dans ce cas, la plaque de céramique est remplacée par une plaque de résine, pouvant supporter une première couche constituée d'une trace métallique de cuivre très fine. La troisième couche de dissipation thermique peut dans ce cas être constituée d'une plaque métallique en aluminium.

Dans le cas où le substrat utilisé est un substrat de type DBC, le module de puissance est robuste et supporte une forte puissance mais a un prix de revient élevé. Dans le cas d'un substrat de type SMI, la trace métallique découpée peut être plus complexe et on peut disposer un plus grand nombre de composants électroniques de puissance sur celui-ci, mais le module est moins résistant aux fortes puissances et aux contraintes d'environnement sévères.

Dans les deux cas, le chemin thermique entre les composants électroniques de puissance et des moyens de refroidissement extérieurs au module de puissance est long puisqu'il nécessite de traverser au moins les différentes couches du substrat.

L'invention vise à remédier aux inconvénients des modules de puissance classiques, en fournissant un ensemble comprenant au moins module de puissance dont la fabrication est peu chère, et dont la structure permet un refroidissement efficace à l'aide de moyens de refroidissement extérieurs.

Le document US 6 703 703 décrit un ensemble comprenant au moins un module de puissance d'un seul tenant, du type comprenant:
- au moins une trace métallique découpée, comportant des pistes entre lesquelles subsistent des interstices qui forment des passages traversant la trace métallique dans son épaisseur,
- au moins un composant électronique de puissance, disposé sur la trace métallique découpée et relié électriquement à la trace métallique découpée,
- un matériau isolant électriquement assurant la cohésion mécanique du module de puissance,
- une face de refroidissement, au moins une partie de cette face de refroidissement comportant la trace métallique découpée, et
- des pattes de raccordement électrique de la trace métallique découpée avec des éléments extérieurs au module. L'ensemble comprend au moins deux modules de puissance, et un organe de logement des modules de puissance, comprenant une face comprenant la face de refroidissement de chaque module de puissance.

L'invention a pour objet un ensemble comportant au moins un module de puissance du type précité, dont la face de refroidissement de chaque module de puissance comporte les pistes de la trace métallique découpée et des parties complémentaires en matériau isolant électriquement qui remplissent les interstices, ces parties complémentaires étant formées par le matériau isolant électriquement assurant la cohésion métallique du module de puissance, cette face de refroidissement étant estimée à être mise en contact direct avec des moyens de refroidissement extérieurs au module.

Le contact entre la trace métallique découpée et les moyens de refroidissement extérieurs est direct, ce qui réduit sensiblement le chemin thermique. De plus, l'absence de couches isolantes et dissipatrices de chaleur entre la trace métallique découpée et les moyens de refroidissement permet de réduire les coûts de fabrication.

Un module de puissance selon l'invention peut en outre comporter l'une ou plusieurs des caractéristiques suivantes :
- les parties complémentaires sont surmoulées autour des pistes de la trace métallique découpée;
- le matériau isolant électriquement forme un boîtier dont le fond constitue au moins une partie de la face de refroidissement ;
- le boîtier comporte un espace intérieur délimité par des parois latérales et contenant le composant électronique de puissance et ses moyens de connexion à la trace métallique découpée, et un matériau de remplissage remplit l'espace libre autour du composant électronique de puissance et de ses moyens de connexion entre les parois latérales ;
- le matériau de remplissage est choisi parmi un gel de silicone et une résine de type époxy ou polyuréthane;
- le matériau isolant électriquement forme un bloc surmoulé autour de la trace métallique découpée et du composant électronique de puissance ;
- le module comporte des pattes de support et de raccordement électrique de la trace métallique découpée à des éléments extérieurs au module ;
- les éléments extérieurs au module de puissance comportent des moyens de commande de celui-ci ;
- le composant électronique de puissance est l'un des éléments parmi une diode, un transistor de type MOS, un transistor de type IGBT et un circuit intégré de type ASIC; et
- le matériau isolant électriquement est une résine de type époxy ou polyuréthane. L'invention a pour objet un ensemble de modules de puissance comportant au moins un module de puissance du type précité, comportant une face comportant la face de refroidissement de chaque module de puissance.

Un ensemble de modules de puissance selon l'invention peut en outre comporter la caractéristique selon laquelle il comporte un boîtier d'assemblage dont le fond constitue au moins une partie de la face comportant la face de refroidissement de chaque module de puissance.

L'invention sera mieux comprise à l'aide de la description qui va suivre, donnée uniquement à titre d'exemple et faite en se référant aux dessins annexés, sur lesquels :
- la figure 1 représente schématiquement en coupe un ensemble de modules de puissance selon un premier mode de réalisation de l'invention ;
- la figure 2 représente schématiquement en coupe un ensemble de modules de puissance selon un second mode de réalisation de l'invention ;
- les figures 3 et 4 sont des agrandissements du détail III de la figure 1 selon deux variantes ; et
- la figure 5 est un agrandissement du détail V de la figure 1 selon une variante.

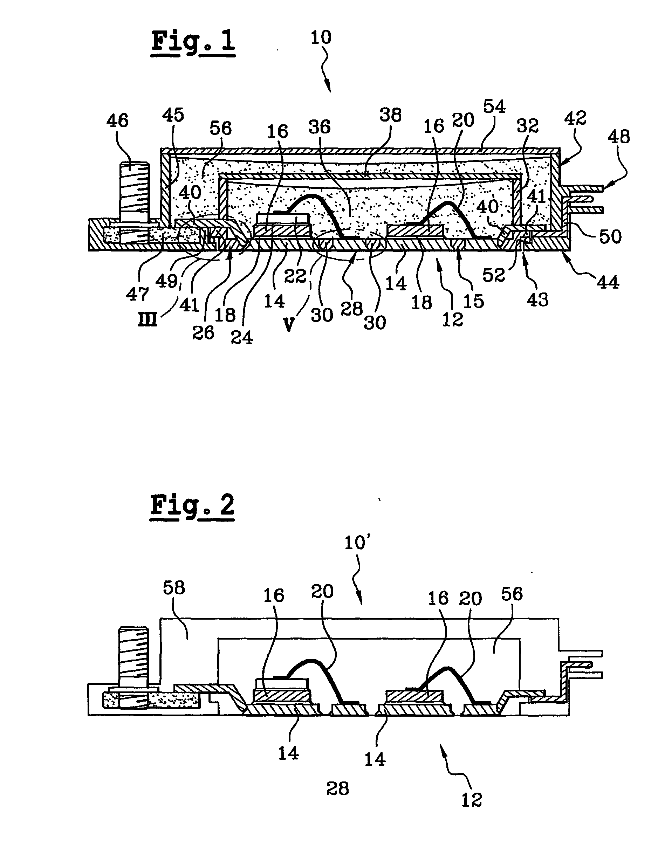

L'ensemble 10 de modules de puissance représenté à la figure 1 peut comporter plusieurs modules de puissance 12, dont un seul est représenté sur cette figure, réunis dans un unique boîtier d'assemblage 42.

Ce module de puissance 12 comporte une trace métallique découpée 14 formant au moins un ensemble de liaisons électriques sur lesquelles sont disposés des composants électroniques de puissance 16. La trace métallique 14 est découpée en pistes entre lesquelles subsistent des interstices 15 qui forment des passages traversant la trace métallique 14 dans son épaisseur. Un composant électronique de puissance 16 est par exemple un composant bipolaire tel qu'une diode, un composant tripolaire tel qu'un transistor de type MOS ou IGBT, ou bien un composant plus complexe tel qu'un circuit intégré de type ASIC.

Dans l'exemple représenté à la figure 1, chaque composant électronique de puissance 16 est fixé à la trace métallique découpée 14 par une brasure 18 permettant aussi un contact électrique entre le composant et la trace métallique. La face libre de chaque composant électronique de puissance 16, opposée à la face brasée à la trace métallique 14 est elle-même connectée électriquement à un autre point de la trace métallique 14.

Cette connexion est assurée par une bande métallique 20 soudée ou brasée, d'une part, à la trace métallique découpée 14 et, d'autre part, soit directement à la face libre du composant électronique de puissance 16, soit à une plaque métallique 22 solidarisée à la face libre du composant électronique de puissance 16 au moyen d'une brasure 24. La bande métallique 20 comporte une section qui est fonction de l'intensité du courant destiné à circuler dans celle-ci. Néanmoins, elle est dimensionnée, en épaisseur et en longueur, de manière à pouvoir se déformer, notamment en raison des dilatations thermiques, sans exercer de contrainte mécanique sur le composant électronique de puissance 16.

Le module de puissance 12 comporte un boîtier en résine 26 contenant les composants 16. Le fond 28 de ce boîtier est composite : il est constitué de la trace métallique découpée 14 qui supporte les composants 16 et de parties en résine 30 complémentaires, qui remplissent les interstices 15 de la trace métallique.

Ainsi, vu en section, le fond 28 apparaît comme une plaque d'un seul tenant, résultant de l'assemblage des pistes métalliques disjointes de la trace métallique découpée 14 et des parties en résine 30, de même épaisseur, qui les réunissent.

Ce fond 28 constitue une face de refroidissement du module de puissance 12 destinée à être mise en contact avec des moyens de refroidissement extérieurs (non représentés).

Une méthode appropriée pour obtenir les parties en résine 30 est de les surmouler autour des pistes de la trace métallique découpée 14. Dans ce cas, chaque interstice 15 est rempli de résine à l'état fondu lors du surmoulage.

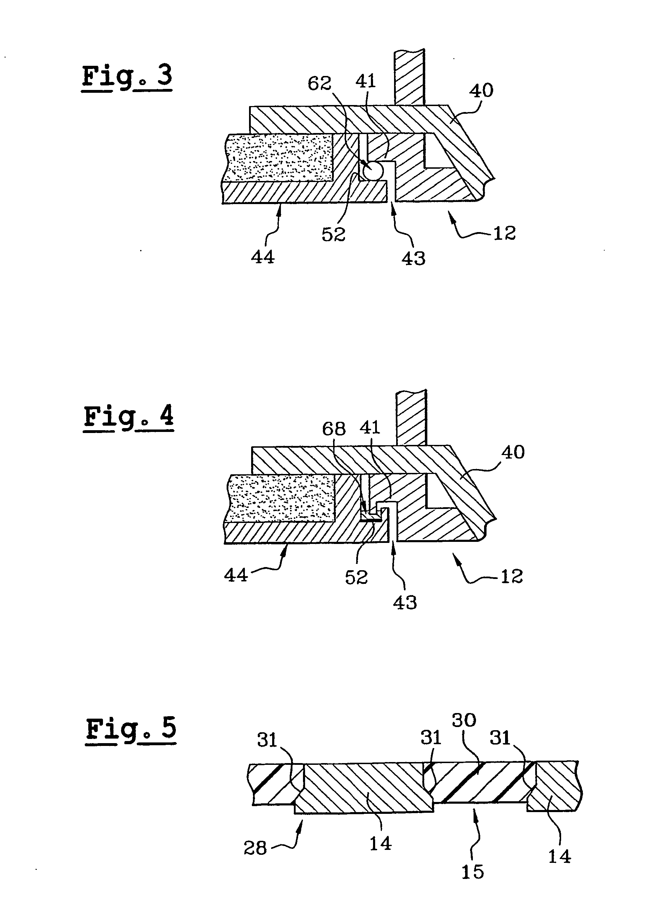

L'accrochage mécanique de chaque partie en résine 30 dans l'interstice 15 qui la contient est assuré par une correspondance de formes. Dans l'exemple illustré, il s'agit de formes en cuvettes, obtenues par rétrécissement de la section de chaque interstice sous la forme de deux plans inclinés opposés 31, comme on le voit à la figure 5.

On comprend que cette forme en cuvette empêche chaque partie en résine 30 de s'échapper de l'interstice 15 par l'extérieur du boîtier 26.

Du côté intérieur au boîtier 26, un matériau de remplissage 36, tel que par exemple un gel de silicone, une résine époxy ou une résine de polyuréthane, remplit l'espace libre autour des composants électroniques de puissance 16 et de leurs moyens de connexion à la trace métallique 14 découpée, entre des parois latérales 32 délimitant le boîtier 26.

Ce matériau de remplissage 36 empêche l'échappement des parties en résine 30 par la face du fond 28 intérieure au boîtier 26.

Ainsi, par l'action combinée des formes en cuvette d'une part, du matériau de remplissage 36 d'autre part, les parties en résine 30 sont solidarisées aux pistes et assurent la tenue mécanique, ou cohésion, de la trace métallique découpée 14.

Cumulativement, le matériau de remplissage 36 forme une masse rigide qui assure la cohésion d'ensemble du module de puissance 12 et en fait un bloc d'un seul tenant.

Un couvercle rigide 38 ferme le boîtier 26. Ce couvercle ne se justifie que dans l'hypothèse où le matériau de remplissage 36 n'est pas suffisamment rigide pour assurer une protection satisfaisante des composants électroniques de puissance 16, ce qui est le cas d'un gel de silicone.

Le module de puissance 12 comporte, traversant chaque paroi latérale 32 du boîtier 26, des pattes 40 de support et de raccordement électrique de la trace métallique avec l'extérieur du module.

Enfin, une collerette périphérique 41 s'étend autour du boîtier 26, juste en-dessous des pattes 40. Cette collerette remplit une fonction d'étanchéité qui sera décrite ultérieurement en référence aux figures 3 et 4.

Le boîtier d'assemblage 42, qui est destiné à contenir plusieurs modules 12, comporte un fond 44 percé d'ouvertures 43 dont chacune est légèrement plus large que le fond 28 du module de puissance correspondant.

Le boîtier d'assemblage 42 comporte également des parois latérales 45, plus hautes que le boîtier 26 du module de puissance 12, de sorte que lesdites parois latérales délimitent entre elles un volume apte à contenir intégralement ledit module de puissance.

Des connecteurs électriques 46, 48 sont prévus sur le boîtier d'assemblage 42 pour raccorder chaque module de puissance 12 à une source de puissance (non représentée) d'une part, à des dispositifs externes (non représentés) d'autre part.

La connexion électrique à la source de puissance s'effectue par un plot conducteur 46 supporté par une excroissance latérale du boîtier d'assemblage 42, cette excroissance contenant une bande métallique 47 qui s'étend depuis la base du plot 46 jusqu'à l'intérieur du boîtier d'assemblage, où une portion terminale de ladite bande métallique 47 pénétrant à l'intérieur du boîtier se trouve dans un réceptacle constitué par le fond 44 du boîtier d'assemblage 42 et par un bord interne 49 en saillie dudit fond. Ce réceptacle débouche vers le haut (par rapport à la figure 1), c'est-à-dire en direction opposée au fond 44. La portion terminale de la bande métallique 47 est ainsi découverte et peut assurer la connexion électrique avec le module de puissance 12, comme cela sera décrit ultérieurement.

Des moyens de connexion sont aussi prévus pour chaque entrée/sortie avec les dispositifs externes. Dans l'exemple illustré, un connecteur externe 48 contient une bande métallique 50 qui s'étend jusqu'à l'intérieur du boîtier d'assemblage 42 en s'appuyant sur le fond et qui présente, comme la bande métallique 47 précédemment décrite, une portion terminale dégagée permettant d'assurer la connexion électrique avec le module de puissance 12.

Le contour de chaque ouverture 43 ménagée dans le fond 44 du boîtier d'assemblage 42 est conformé en un épaulement 52 dont la portée est dirigée vers l'intérieur dudit boîtier 42 d'assemblage.

Cet épaulement est dimensionné pour coopérer avec la collerette périphérique 41 du boîtier 26 du module de puissance 12, de manière que la face externe du fond 28 dudit boîtier 26 se trouve à affleurement de la face externe du fond 44 du boîtier d'assemblage 42.

Ainsi, chaque boîtier 26 de module de puissance 12 obture l'ouverture 43 correspondante du boîtier d'assemblage 42 en prolongeant le fond 44 de celui-ci.

Un matériau de remplissage 56 remplit le volume laissé dans le boîtier d'assemblage 42, autour des modules de puissance 12, et un couvercle optionnel 54 recouvre la totalité du volume intérieur du boîtier d'assemblage en étant assujetti à l'extrémité supérieure des parois latérales 42.

On va maintenant décrire la mise en place d'un ou plusieurs modules de puissance 12 dans le boîtier d'assemblage 42.

Le boîtier d'assemblage 42, dépourvu de couvercle, étant présenté dans la position représentée à la figure 1, chaque module de puissance 12 est engagé par le dessus à l'intérieur du boîtier d'assemblage 42, au droit d'une ouverture 43 correspondante.

Le fond 28 de chaque module de puissance 12 pénètre dans l'ouverture 43 correspondante et vient se placer dans le même plan que le fond du boîtier d'assemblage 42 tandis que sa collerette périphérique 41 prend place dans l'épaulement 52 formé dans le contour de l'ouverture 43.

Simultanément, les pattes 40 de support et de raccordement électrique viennent prendre place sur les bandes métalliques 47 et 50 des connecteurs 46 et 48 du boîtier d'assemblage 42.

Le module de puissance 12 repose alors par ses pattes 40 de support et de raccordement dans le boîtier d'assemblage 42. Les pattes 40 de support et de raccordement sont ensuite brasées ou soudées aux bandes métalliques 47 et 50 pour assurer une connexion de qualité avec l'extérieur.

Après cette opération, le matériau de remplissage 56 est introduit dans le boîtier d'assemblage 42 pour occuper tout le volume disponible autour des modules de puissance 12, puis le boîtier d'assemblage est fermé par mise en place du couvercle 54.

L'ensemble 10' de modules de puissance représenté à la figure 2 est un second mode de réalisation de l'invention.

Dans ce mode de réalisation, le boîtier 26 est remplacé par un bloc de résine 56 de même volume, surmoulé autour de la trace métallique découpée 14, des composants électroniques de puissance 16 et des bandes métalliques 20. Comme précédemment, la trace métallique 14 constitue une partie du fond 28 du module de puissance 12 destiné à être mis en contact avec des moyens de refroidissement extérieurs.

Dans ce mode de réalisation, le boîtier d'assemblage 42 est remplacé par un autre bloc de résine 58, surmoulé autour du bloc de résine 56 qui présente un volume identique à celui du boîtier d'assemblage 42.

Les contacts électriques entre les pattes 40 de support et de raccordement et les connecteurs 46 et 48 de l'ensemble 10' sont identiques à ceux de l'ensemble 10.

Sur la figure 3, on voit en détail une patte 40 de support et de raccordement 40 du module de puissance 12 reposant sur le fond 44 de l'ensemble 10 de modules de puissance de la figure 1.

On voit également que la collerette 41, en reposant sur l'épaulement 52, assure la fermeture étanche de l'ouverture 43 du boîtier d'assemblage 42, ce qui permet de verser le matériau de remplissage 56 dans le boîtier d'assemblage 42 avant de fermer le couvercle 54.

Dans la présente description, on entend par fermeture étanche une obturation suffisante pour que le matériau de remplissage 56 ne s'échappe pas par le fond du boîtier d'assemblage 42.

Une première solution pour assurer cette étanchéité est représentée à la figure 3 et consiste à disposer un ruban adhésif 62 entre la collerette 41 et l'épaulement 52.

Une autre solution, représentée à la figure 4, consiste à prévoir une saillie sur chacune des deux faces en regard que constituent la collerette 41 et l'épaulement 52, cette saillie se trouvant sur l'arête libre de ladite face, de sorte qu'elle délimite avec ladite face une gorge apte à recevoir la saillie de l'autre face.

Le fond de la gorge formée sur l'épaulement 52 est garni d'un adhésif 68 contre lequel s'appuie la saillie de la collerette 41.

La figure 5 représente un détail du fond 28 du module de puissance 12 selon une variante de réalisation. On voit sur cette figure que, dans cette variante, la trace métallique découpée 14 est protubérante par rapport à la résine surmoulée 30. Ainsi, lorsque le fond 28 est mis en contact avec des moyens de refroidissement extérieurs, c'est la trace métallique découpée 14 qui est en contact direct avec ces derniers.

Cette configuration est obtenue par une forme appropriée de l'empreinte du moule utilisé pour surmouler la trace métallique découpée 14.

Il apparaît clairement qu'un module de puissance selon l'invention est simple de conception et permet un contact direct entre les éléments dissipateurs d'énergie thermique du module de puissance, d'une part, et des moyens de refroidissement extérieurs au module.

On notera enfin que l'invention n'est pas limitée au mode de réalisation décrit précédemment.

En effet, en variante, la face de la trace métallique destinée à être mise en contact direct avec les moyens de refroidissement extérieurs affleure la face correspondante du fond 28 du boîtier 26.

## Revendications

1. Ensemble comprenant au moins un module de puissance (12) d'un seul tenant, chaque module comprenant:
- au moins une trace métallique découpée (14), comportant des pistes entre lesquelles subsistent des interstices (15) qui forment des passages traversant la trace métallique (14) dans son épaisseur,
- au moins un composant électronique de puissance (16), disposé sur la trace métallique découpée et relié électriquement à la trace métallique découpée,
- un matériau (30, 56) isolant électriquement assurant la cohésion mécanique du module de puissance,
- une face de refroidissement, au moins une partie de cette face de refroidissement (28) comportant la trace métallique découpée (14), et
- des pattes (40) de raccordement électrique de la trace métallique découpée (14) avec des éléments extérieurs au module (12), l'ensemble comprenant au moins deux modules de puissance, et un organe (42, 58) de logement des modules de puissance (12), comprenant une face comprenant la face de refroidissement (28) de chaque module de puissance (12),
**caractérisé en ce que** la face de refroidissement (28) de chaque module de puissance (12) comporte les pistes de la trace métallique découpée et des parties complémentaires en matériau isolant électriquement qui remplissent les interstices (15), ces parties complémentaires étant formées par le matériau (30, 56)isolant électriquement assurant la cohésion métallique du module de puissance (12), cette face étant destinée à être mise en contact direct avec des moyens de refroidissement extérieurs au module.

2. Ensemble selon la revendication 1, **caractérisé en ce que** l'organe de logement est un boîtier d'assemblage (42) dont le fond (44) constitue au moins une partie de la face comportant la face de refroidissement (28) de chaque module de puissance (12).

3. Ensemble selon la revendication 1 ou 2, **caractérisé en ce que**, les pattes de raccordement (40) étant logées dans l'organe de logement (42, 58), lesdits pattes sont raccordées à des connecteurs (46, 48) de raccordement électrique de l'ensemble (10) avec une source de puissance et des dispositifs externes.

4. Ensemble selon la revendication 3, **caractérisé en ce qu'**il comporte des bandes métalliques (47) de raccordement électrique des pattes de raccordement (40) de chaque module aux connecteurs de raccordement (46).

5. Ensemble selon l'une quelconque des revendications précédentes, **caractérisé en ce que** les parties complémentaires (30 ; 56) sont surmoulées autour des pistes de la trace métallique découpée (14).

6. Ensemble selon l'une quelconque des revendications 1 à 5, **caractérisé en ce qu'**il comporte un boîtier (26) comportant un espace intérieur délimité par des parois latérales (32) et contenant un composant électronique de puissance (16) et ses moyens de connexion à la trace métallique découpée (14), et **en ce qu'**un matériau de remplissage (36) remplit l'espace libre autour du composant électronique de puissance et de ses moyens de connexion entre les parois latérales (32).

7. Ensemble selon la revendication 6, **caractérisé en ce que** le matériau de remplissage (36) est choisi parmi un gel de silicone et une résine de type époxy ou polyuréthane.

8. Ensemble selon l'une quelconque des revendications 1 à 5, **caractérisé en ce que** le matériau isolant électriquement (56) forme un bloc surmoulé autour de la trace métallique découpée (14) et d'un composant électronique de puissance (16).

9. Ensemble selon l'une quelconque des revendications 1 à 8, **caractérisé en ce que** les éléments extérieurs au module de puissance comportent des moyens de commande de celui-ci.

10. Ensemble selon l'une quelconque des revendications 1 à 9, **caractérisé en ce que** le composant électronique de puissance (16) est un élément choisi parmi une diode, un transistor de type MOS, un transistor de type IGBT et un circuit intégré de type ASIC.

11. Ensemble selon l'une quelconque des revendications 1 à 10, **caractérisé en ce que** le matériau (30 ; 56) isolant électriquement est une résine de type époxy ou polyuréthane.

## Claims

1. An assembly comprising at least one power module (12) being all in one piece, each power module comprising:
- at least one cut-out metal trace (14), comprising tracks between which there remain gaps (15) forming passages through the thickness of the metal trace (14)
- at least one electronic power component (16), arranged onto the cut-out metal trace and electrically connected with this metal trace,
- an electrically insulating material (30, 56) providing the power module with cohesion,
- a cooling face, at least a portion of said cooling face (28) comprising the cut-out metal trace (14),
- tabs (40) for electrically connecting the cut-out metal trace to elements external to the module,
wherein the assembly comprises at least two power modules, and an assembly housing (42, 58) for said power modules (12), comprising a face including the cooling face (28) of each power module (12),
**characterized in that** the cooling face (28) of each power module (12) comprises the tracks of the cut-out metal trace and electrically-insulating complementary portions (30; 56) which fill the gaps (15), these complementary portions being constituted by the insulating material (30, 56) providing the power module (12) with cohesion, this face being designed to be put into direct contact with cooling means external to the module.

2. An assembly according to claim 1, **characterized in that** the housing is an assembly package (42) whose bottom (44) constitutes at least a portion of the face including the cooling face (28) of each power module (12).

3. An assembly according to claim 1 or claim 2, **characterized in that** the tabs (40) are housed into the housing (42, 58), said tabs being connected to connectors (46, 48) for electrically connecting the assembly (10) with a power source and external devices.

4. An assembly according to claim 3, **characterized in that** it comprises metal strips (47) for electrically connecting the tabs (40) of each module with the connectors (46).

5. An assembly according to any one of preceding claims, **characterized in that** the complementary portions (30; 56) are overmolded around the tracks of the cut-out metal trace (14).

6. An assembly according to any one of claims 1 to 5, **characterized in that** it comprises a package (26) including an inside space defined by side walls (32) and containing the electronic power component (16) and its means for connection to the cut-out metal trace (14), and **in that** a filler material (36) fills the empty space around the electronic power component and its connection means between the side walls (32).

7. An assembly according to claim 6, **characterized in that** the filler material (36) is selected from a silicone gel and an epoxy or polyurethane type resin.

8. An assembly according to any one of claims 1 to 5, **characterized in that** the electrically-insulating material (56) forms an overmolded block around the cut-out metal trace (14) and the electronic power component (16).

9. An assembly according to any one of claims 1 to 8, **characterized in that** the elements external to the power module include means for controlling it.

10. An assembly according to any one of claims 1 to 9, **characterized in that** the electronic power component (16) is one of the elements selected from: a diode; a MOS type transistor; an IGBT type transistor; and an ASIC type integrated circuit.

11. An assembly according to any one of claims 1 to 10, **characterized in that** the electrically-insulating material (30; 56) is a resin of epoxy or polyurethane type.

## Patentansprüche

1. Baugruppe, umfassend zumindest ein Energiemodul (12) aus einem Stück, wobei jedes Modul umfasst:
- zumindest einen aufgeteilten metallischen Leiter (14), welcher Bahnen aufweist, zwischen denen Zwischenräume (15) bestehen, welche Passagen bilden, die den metallischen Leiter (14) in seiner Dicke durchziehen,
- zumindest ein elektronisches Energiebauteil (16), das auf dem aufgeteilten metallischen Leiter angeordnet und mit dem aufgeteilten metallischen Leiter elektrisch verbunden ist,
- ein elektrisch isolierendes Material (30, 56), das die mechanische Kohäsion des Energiemoduls gewährleistet,
- eine Kühlfläche, wobei zumindest ein Teil dieser Kühlfläche (28) den aufgeteilten metallischen Leiter (14) umfasst, und
- Laschen (40) zum elektrischen Anschluss des aufgeteilten metallischen Leiters (14) an Elemente außerhalb des Moduls (12),
wobei die Baugruppe zumindest zwei Energiemodule umfasst, sowie ein Organ (42, 58) zur Unterbringung der Energiemodule (12), umfassend eine Fläche, welche die Kühlfläche (28) jedes Energiemoduls (12) umfasst,
**dadurch gekennzeichnet, dass** die Kühlfläche (28) jedes Energiemoduls (12) die Bahnen des aufgeteilten metallischen Leiters und komplementäre Teile aus elektrisch isolierendem Material aufweist, welche die Zwischenräume (15) füllen,
wobei diese komplementären Teile aus dem elektrisch isolierenden Material (30, 56) gebildet werden, das die metallische Kohäsion des Energiemoduls (12) gewährleistet, wobei diese Fläche dazu bestimmt ist, in direkten Kontakt mit Kühlmitteln außerhalb des Moduls gebracht zu werden.

2. Baugruppe nach Anspruch 1, **dadurch gekennzeichnet, dass** das Unterbringungsorgan ein Montagegehäuse (42) ist, dessen Boden (44) zumindest einen Teil der Fläche bildet, welche die Kühlfläche (28) jedes Energiemoduls (12) umfasst.

3. Baugruppe nach Anspruch 1 oder 2, **dadurch gekennzeichnet, dass**, bei im Unterbringungsorgan (42, 58) untergebrachten Anschlusslaschen (40), besagte Laschen an Anschlussteile (46, 48) zum elektrischen Anschluss der Baugruppe (10) an eine Energiequelle und externe Vorrichtungen angeschlossen sind.

4. Baugruppe nach Anspruch 3, **dadurch gekennzeichnet, dass** sie metallische Bänder (47) zum elektrischen Anschluss der Anschlusslaschen (40) jedes Moduls an die Anschlussteile (46) umfasst.

5. Baugruppe nach einem der vorstehenden Ansprüche, **dadurch gekennzeichnet, dass** die komplementären Teile (30, 56) um die Bahnen des aufgeteilten metallischen Leiters (14) aufgeformt sind.

6. Baugruppe nach einem der Ansprüche 1 bis 5, **dadurch gekennzeichnet, dass** sie ein Gehäuse (26) umfasst, das einen Innenraum aufweist, der von Seitenwänden (32) begrenzt ist und ein elektronisches Energiebauteil (16) und dessen Mittel zur Verbindung mit dem aufgeteilten metallischen Leiter (14) enthält, und dass ein Füllmaterial (36) den freien Raum um das elektronische Energiebauteil und dessen Verbindungsmittel zwischen den Seitenwänden (32) füllt.

7. Baugruppe nach Anspruch 6, **dadurch gekennzeichnet, dass** das Füllmaterial (36) aus einem Silikongel und einem Epoxid- oder Polyurethanharz ausgewählt ist.

8. Baugruppe nach einem der Ansprüche 1 bis 5, **dadurch gekennzeichnet, dass** das elektrisch isolierende Material (56) einen Block bildet, der um den aufgeteilten metallischen Leiter (14) und ein elektronisches Energiebauteil (16) aufgeformt ist.

9. Baugruppe nach einem der Ansprüche 1 bis 8, **dadurch gekennzeichnet, dass** die Elemente außerhalb des Energiemoduls Mittel zur Steuerung desselben umfassen.

10. Baugruppe nach einem der Ansprüche 1 bis 9, **dadurch gekennzeichnet, dass** das elektronische Energiebauteil (16) ein Element ist, das aus einer Diode, einem MOS-Transistor, einem IGBT-Transistor und einer integrierten ASIC-Schaltung ausgewählt ist.

11. Baugruppe nach einem der Ansprüche 1 bis 10, **dadurch gekennzeichnet, dass** das elektrisch isolierende Material (30, 56) ein Epoxid- oder Polyurethanharz ist.
